# EUROPEAN PATENT SPECIFICATION

(11) **EP 4 515 602 B1**
(45) Date of publication and mention of the grant of the patent: **06.05.2026**
(21) Application number: 22945251.1
(22) Date of filing: 08.06.2022
(51) Int. Cl.: H10F 77/123, H10F 77/169, H10F 77/42

(54) **METHOD FOR MANUFACTURING CDTE BASED THIN FILM SOLAR CELL WITH GRADED REFRACTIVE INDEX PROFILE WITHIN THE CDTE-BASED ABSORBER LAYER AND CDTE BASED THIN FILM SOLAR CELL WITH GRADED REFRACTIVE INDEX PROFILE**
VERFAHREN ZUR HERSTELLUNG EINER CDTE-BASIERTEN DÜNNSCHICHTSOLARZELLE MIT GRADIERTEM BRECHUNGSINDEXPROFIL INNERHALB DER CDTE-BASIERTEN ABSORBERSCHICHT UND CDTE-BASIERTE DÜNNSCHICHTSOLARZELLE MIT GRADIERTEM BRECHUNGSINDEXPROFIL
PROCÉDÉ DE FABRICATION D'UNE CELLULE SOLAIRE À FILM MINCE À BASE DE CDTE AVEC UN PROFIL D'INDICE DE RÉFRACTION GRADUÉ DANS LA COUCHE ABSORBANTE À BASE DE CDTE ET CELLULE SOLAIRE À FILM MINCE À BASE DE CDTE AVEC UN PROFIL D'INDICE DE RÉFRACTION GRADUÉ

(43) Date of publication of application: 05.03.2025
(73) Proprietor: China Triumph International Engineering Co., Ltd., Shanghai 200063 (CN); CTF Solar GmbH, 01099 Dresden (DE)
(72) Inventor: PENG, Shou, Shanghai 200063 (CN); MA, Liyun, Shanghai 200063 (CN); FU, Ganhua, Shanghai 200063 (CN); YIN, Xinjian, Shanghai 200063 (CN); ARNDT, Robert, 01099 Dresden (DE); SWOBODA, Marko, 01099 Dresden (DE)
(74) Representative: Kailuweit & Uhlemann Patentanwälte Partnerschaft mbB
(86) International application number: PCT/CN2022/097642
(87) International publication number: WO 2023/236106

(56) References cited:
- WO-A1-2018/119685
- CN-A- 102 244 110
- CN-A- 102 779 860
- CN-A- 113 555 458
- US-A1- 2010 180 935
- US-A1- 2013 074 914
- US-A1- 2014 360 565
- US-A1- 2015 144 186
- US-A1- 2020 058 818
- US-A1- 2021 143 288
- KRAFT D ET AL: "Alternative back contacts for CdTe solar cells: a photoemission study of the VSe"2/CdTe and TiSe"2/CdTe interface formation", THIN SOLID FILMS, ELSEVIER, AMSTERDAM, NL, vol. 431-432, May 2003 (2003-05-01), pages 382 - 386, XP004428672, ISSN: 0040-6090, DOI: 10.1016/S0040-6090(03)00254-2
- GAUNEAU M ET AL: "Impurities and dopants in vanadium doped CdTe", OPTICAL MATERIALS, vol. 7, January 1997 (1997-01-01), pages 21 - 31, XP093323136

## Description

The invention concerns a method for manufacturing a CdTe based thin film solar cell with a graded refractive index profile within the CdTe-based absorber layer and a CdTe based thin film solar cell with a graded refractive index profile.

In the state of the art, CdTe based thin film solar cell devices are produced in superstrate configuration with the following process sequence: on a usually transparent substrate, like a glas substrate a first electrode layer is deposited as a front contact. On this, a CdTe based absorber layer is deposited. The CdTe based absorber layer is then activated with an activating agent, e.g. CdCl₂, and a temperature treatment step. Finally, a second electrode layer, e.g. metal layer or a metal compound layer, is applied as a back contact to collect the charge carriers. CdTe based thin film solar cell devices in substrate configuration are known from state of the art as well. It is also well known to include additional layers before depositing the CdTe based absorber layer and before depositing the back contact, like buffer layers.

Differences between the refractive index of the glass substrate comprising the front electrode and the CdTe based absorber layer lead to degraded coupling of light into the CdTe based absorber layer and therefore limit the photovoltaic efficiency of the thin film solar cell device. In particular, in cases without a CdS layer formed between the front electrode and the CdTe absorber layer, the difference between the front glass having a refractive index of 1.5 to 1.7 and the CdTe layer having a refractive index of 2.95 is very high, resulting in a significant amount of incident light reflected at the interface to the CdTe layer. In some devices, a CdSeTe absorber layer having a high amount of Se at this interface is formed, e.g. in US 2014/0360565 A1. However, even pure CdSe has a refractive index of 2.54 resulting in still a large difference of refractive indices.

Furthermore, doping, in particular p-doping, or increasing p-doping level of the CdTe based absorber layer is important to achieve high efficiency solar cells. P-doping with copper is well known, but is associated with draw backs, like lack of long-term stability.

WO 2017 / 081477 A1 discloses a method for preparation of a Cu-doped CdTe based thin film solar cell, wherein a continuous organic layer is applied between an absorber layer and a back contact. The copper may be incorporated into the CdTe absorber layer by providing Cu onto the CdTe absorber layer by thermal evaporation or by treating the surface of the organic layer with Cu.

EP 2 337 088 A2 discloses a method for p-doping cadmium telluride (CdTe), wherein CdTe is provided with an interfacial region and subjecting at least a portion of the interfacial region to a thermal treatment. The thermal treatment is performed in the presence of a first material comprising a p-type dopant like Bi, P, As, Sb, Au, Ag or Cu and a second material comprising a halogen like cadmium chloride, hydrochloric acid or chlorine gas.

However, some of the used doping elements create sub-bandgap defects reducing efficiency of the solar device.

It is therefore an aim of the invention to provide a method for manufacturing a CdTe based thin film solar cell device with improved efficiency and a respective CdTe based thin film solar cell device.

The object is solved by a method for manufacturing a CdTe based thin film solar cell device with a graded refractive index profile within the CdTe-based absorber layer and by a CdTe based thin film solar cell device with a graded refractive index profile according to the independent claims. Preferred embodiments are given in the dependent claims.

According to the invention a method for manufacturing a CdTe based thin film solar cell device with a graded refractive index profile within the CdTe-based absorber layer, comprises at least the following steps: a) providing a transparent substrate comprising a front electrode, b) forming a doped CdTe based absorber layer on the substrate and c) performing an activation treatment after step b). According to the invention, the doped CdTe based absorber layer in step b) is formed as a doped CdTe based absorber layer stack comprising a first and a second layer. The first layer is formed as a first doping element containing layer comprising vanadium as a first doping element. It is formed by depositing a first doping element-rich layer and subsequently depositing a CdSe layer or a CdSeTe layer, or by depositing a CdSe layer or a CdSeTe layer each doped with the first doping element. The second layer is formed by depositing a CdTe layer.

Advantageously, this method enables manufacturing of a CdTe based thin film solar cell device with a gradient of the first doping element within the CdTe based absorber layer with a high concentration of the first doping element at a first interface of the CdTe based absorber layer directed towards the substrate. The gradient may have any known non-linear shape along a thickness of the CdTe based absorber layer. Furthermore advantageously, this method enables manufacturing a CdTe based thin film solar cell device with a graded refractive index profile within the CdTe based absorber layer with a lowest refractive index at the first interface of the CdTe based absorber layer. The refractive index at the first interface of the CdTe based absorber layer lies in the range of 2.0 to 2.5, whereas the refractive index increases over the thickness of the CdTe based absorber layer and reaches a value in the range of 2.5 to 3 at a second interface of the CdTe based absorber layer directed towards a back contact. The refractive index is indirectly coupled with the concentration of the first doping element. In embodiments, the concentration of the first doping element within the whole CdTe based absorber layer is in the range of 0.001 to 1 wt.-%, wherein a concentration of vanadium at the first interface of the CdTe based absorber layer lies in the range of 10¹⁵ to 10²⁰ cm⁻³ and decreases towards the second interface of the CdTe based absorber layer. Furthermore, such a graded refractive index forms a smooth transition of the refractive index of the substrate to the CdTe based absorber layer at the first interface of the absorber layer. Formation of the graded refractive index profile and doping of the CdTe based absorber layer is advantageously promoted by the activation treatment in step c). Furthermore, this enables improved coupling of light into the CdTe based absorber layer from the front electrode.

According to the invention, a substrate means any transparent basis on which the CdTe based absorber layer is formed in step b) and which comprises a front electrode. The substrate may comprise a transparent base substrate, for instance a glass substrate, a transparent front electrode and further layers like buffer layers, window layers or any else. In embodiments, the front electrode is a front electrode layer or a front electrode layer stack. In further embodiments, the front electrode is an n-type front electrode. The front electrode may be made of or may comprise a transparent conductive oxide. A buffer layer means a layer or a layer stack used for instance for energy band alignment.

The doped CdTe based absorber layer may be deposited by a variety of different methods known from state of the art, like physical vapour deposition (PVD), electrochemical deposition and so on. In embodiments the doped CdTe based absorber layer is deposited by close space sublimation (CSS). In further embodiments, the doped CdTe based absorber layer is a p-doped CdTe based absorber layer or at least comprises a p-doped region.

A CdSeTe layer means a layer with the composition CdSeₓTe₁₋ₓ, wherein x varies between 0 (zero) and 1, preferably between 0 and 0.4.

The first doping element is vanadium. Advantageously, vanadium as doping element achieves high doping densities, almost two orders of magnitude higher than for copper doping, resulting in higher open circuit voltage of the thin film solar cell device. Furthermore advantageously, due to the amphoteric character of vanadium depending on the oxidation state p-doping as well as n-doping of the CdTe based absorber layer can be achieved. Vanadium as first doping element advantageously reduces sub-bandgap related features, like recombination from defects and resulting losses in quantum efficiency and therefore reduced overall efficiency of the thin film solar cell device, known from other doping elements, like group 15 elements. Furthermore advantageously, vanadium as first doping element influences the refractive index of the CdTe based absorber layer.

In some embodiments it is beneficial, to either provide a source of oxygen through an additionally deposited oxygen containing layer or to deposit the first layer of the doped CdTe based absorber layer in vacuum or an inert atmosphere each with an additional O₂ partial pressure.

In embodiments, the first layer of the doped CdTe based absorber layer stack is formed by depositing a CdSe layer or a CdSeTe layer each doped with vanadium under vacuum or an inert atmosphere with an additional O₂ partial pressure, wherein the additional O₂ partial pressure is in the range of 10⁻³ Pa to 1 Pa. In further embodiments, the first layer of the doped CdTe based absorber layer stack is formed by depositing a vanadium-rich layer and subsequently a CdSe layer or a CdSeTe layer under vacuum or an inert atmosphere each with an additional O₂ partial pressure, wherein the additional O₂ partial pressure is in the range of 10⁻³ Pa to 1 Pa. Advantageously, a change of doping-type within the CdTe based absorber layer can be achieved. All deposition processes may be achieved by any known method, for instance by evaporation or sputtering using respective sources, for instance CdSe respectively CdSeTe material premixed with vanadium.

Vacuum means a pressure in the range below 10⁻⁴ Pa to 100 Pa. Inert atmosphere means any dry atmosphere with a relative oxygen content below 0.05 %.

In further embodiments, the second layer of the CdTe based absorber layer stack is formed as a layer stack, at least comprising a CdTe layer. In further embodiments, the layer stack may comprise additional layers, like layers containing for instance a second doping element.

The activation treatment of the present invention induces recrystallization, reduces lattice defects and improves the pn-junction or its formation. Furthermore, this step also improves intermixing of different compounds and/or elements resulting in forming of mixed or doped compounds. The activation treatment is known from the state of the art, wherein, however, parameters of the activation treatment according to the invention may differ from that of the prior art. Such parameters are, for instance, temperature, time or duration, the kind or the amount of the chemical activation agent or the composition and pressure of a surrounding atmosphere. In embodiments, the activation treatment comprises a step of applying an activation agent and a step of a thermal treatment. This activation agent may, for instance, be CdCl₂ or a composition comprising chlorine or chlorine ions or any other agent comprising halogen ions. The activation agent may be applied to the CdTe based absorber layer as a solid, a liquid or a gaseous material using techniques known to a person skilled in the art. Furthermore, the thermal treatment is performed at temperatures in the range of 350°C to 500°C, preferably in the range of 400°C to 450°C, for a duration of 5 to 30 minutes.

In embodiments, the doped CdTe based absorber layer is formed with a total thickness in the range of 2 µm to 5 µm, preferably 3 µm.

In further embodiments, the first layer of the CdTe based absorber layer is formed with a thickness in the range of 0.5 µm to 3.5 µm. In embodiments, the first doping element-rich layer is formed with a thickness in the range of 5 nm to 500 nm. In further embodiments, the CdSe respectively CdSeTe layer is deposited with a thickness in the range of 5 nm to 500 nm, wherein the thickness of the first doping element-rich layer and of the undoped CdSe or CdSeTe layer correspond to each other in dependence on the concentration of vanadium to be reached in the first layer of the CdTe based absorber layer. The CdSe respectively CdSeTe layer each doped with the first doping element is deposited with a thickness in the range of 5 nm to 500 nm. In embodiments, the second layer of the CdTe based absorber layer is formed with a thickness in the range of 2 µm to 4 µm.

In embodiments, the first doping element-rich layer is at least one out of the group comprising VTe₂, VSe₂, V, VO₂, NH₄VO₂, VCl₂, VCl₄.

Such a first doping element-rich layer may be formed by any known method, for instance physical vapour deposition or chemical vapour deposition methods as well as methods comprising applying a chemical agent followed by annealing under certain atmospheres. In embodiments a VCl₄ or VCl₂ layer may be formed by the reaction 2 VCl₃ → VCl₄ + VCl₂.

In embodiments, the substrate provided in step a) further comprises an oxygen containing layer.

Advantageously this layer may serve as a source of oxygen during following process steps.

In further embodiments, the oxygen containing layer is a layer or layer stack comprising a high sheet resistance, a band gap higher as 3.4 eV, a valence band edge lower than the valence band edge of the CdTe based absorber layer and a conduction band edge comparable to the CdTe based absorber layer. In embodiments, the oxygen containing layer has a thickness in the range of 1 nm to 50 nm. In further embodiments the oxygen containing layer has an average transmission of at least 80% of incident electromagnetic radiation having a wavelength in a range from about 250 nm to about 1050 nm.

In embodiments, the oxygen containing layer is an oxidic buffer layer.

Advantageously, the oxidic buffer layer serves as a source of oxygen influencing the amphoteric character of the first doping element vanadium and therefore the achievable doping type of the CdTe based absorber layer. In further embodiments the oxidic buffer layer may be, but not limiting ZnO, SnO₂ or Mg doped ZnO.

In embodiments, the second layer of the CdTe based absorber layer stack is doped with the first and/or a second doping element.

Advantageously, the second doping element forms a gradient of the second doping element promoted by the activation treatment in step c) within the CdTe based absorber layer with a high concentration of the second doping element at the second interface of the CdTe based absorber opposite to the first interface. Furthermore advantageously, the second doping element forms a diffusive counter-pressure within the CdTe based absorber layer limiting diffusion of the first doping element towards the second interface of the CdTe based absorber layer during the activation treatment by already occupying lattice positions also suitable for the first doping element.

It is obvious that the second doping element differs from the first doping element. In embodiments, the first and the second doping element are elements of the same type or different type of doping elements. The type of doping element means a p-type respectively an n-type doping element. For instance, it may be advantageous, if the first doping element is an n-type doping element, the second doping element is a p-type doping element or vice versa or the first and the second doping material are both p-type doping materials or both n-type doping materials. Furthermore, the type of the doping element may vary depending on its oxidation state of the doping material.

In embodiments, the second doping element is selected out of group 11 and group 15 elements of the periodic table of elements. Advantageously this enables manufacturing a copper free CdTe based thin film solar cell device. In further embodiments, the second doping element is selected out of N, P, As, Ag, Cu and Sb. In embodiment, the concentration of the second doping element within the CdTe based absorber layer is in the range of 10¹⁵ to 10²⁰ cm⁻³.

In embodiments, the doped second layer of the CdTe based absorber layer stack is formed by any known method, like co-deposition of CdTe and the second doping element, deposition of a layer containing the second doping element subsequently followed by deposition of CdTe or vice versa or between two depositions of CdTe. Furthermore also ex-situ doping methods of the second layer of the CdTe based absorber layer are possible and may be performed before or after step c), for instance known from US 202180735 A1.

In embodiments, the method further comprises a step d) of forming a back contact.

In further embodiments, the back contact may be formed as a back contact layer stack. Forming of the back contact may be done by any known method.

In further embodiments, the method comprises further steps prior to forming the back contact, for instance a known Cd etching step to form a Te-rich surface layer at the second interface of the CdTe based absorber layer. The second interface of the CdTe based absorber layer directs towards the back contact.

In embodiments, the back contact is formed by forming a back contact layer stack, comprising a first back contact layer and a second back contact layer, wherein the first back contact layer is a Te-rich layer and the second back contact layer is a metal layer or a high resistance layer.

Advantageously, such a Te-rich layer serves as buffer layer for the metal layer or metal nitride layer and forms a barrier. Furthermore advantageously, by forming such a back contact layer stack, a known Cd etching step for forming a Te-rich surface layer at the second interface of the CdTe bases absorber layer may be omitted. In embodiments, the Te-rich layer is selected out of ZnTe, SbTe, Te.

In further embodiments, the Te-rich layer may be formed by known etching steps, like NP etching step.

In further embodiments, the Te-rich layer may be doped with a group 11 or group 15 element, preferably with Ag, Cu or N, P, As, Sb. This is advantageously, if the second layer of the CdTe based absorber layer stack is undoped, i.e. does not comprise the first and/or the second doping element. In this case, the group 11 or group 15 doping element of the Te-rich layer serves as the second doping element forming a gradient of the second doping element during an additional thermal treatment within the CdTe based absorber layer with a high concentration of the second doping element at the second interface of the CdTe based absorber layer. The additional thermal treatment is performed after forming the back contact by annealing in air for a duration of 5 minto 60 min at a temperature in the range of 200°C to 280°C. In further embodiments, the Te-rich layer comprises the group 11 or group 15 element in the range of 0.01 wt.-% to 3 wt.-%.

In further embodiments, the metal layer is a highly conductive metal layer with a sheet resistance of 5 ohm respectively ohm·sq⁻¹ or lower. Highly conductive metal layers are for instance but not limiting Mo, Al, Cr or Au.

A high resistance layer is a layer with a sheet resistance of at least 100 ohm respectively ohm·sq⁻¹. In embodiments, the high resistance layer is a metal nitride layer, like for instance but not limiting MoN, AIN.

In embodiments, the Te-rich layer is formed with a thickness in the range of 50 nm to 500 nm. Furthermore, the metal layer respectively metal nitride layer may be formed with a thickness in the range of 10 nm to 1000 nm respectively in the range of 10 nm to 100 nm.

In embodiments, the activation treatment is performed under inert atmosphere or vacuum.

In embodiments, the activation treatment is performed under inert atmosphere or vacuum with an H₂ partial pressure. Advantageously, H₂ removes species bound to the first doping element, for instance oxygen from the vanadium. Vacuum means a pressure in the range of 10⁻⁴ Pa to 100 Pa. Inert atmosphere means any dry atmosphere with a total oxygen amount of below 0.05%. In further embodiments, the H₂ partial pressure is in the range of 10⁻³ Pa to 1 Pa.

The invention further concerns a CdTe based thin film solar cell device with a graded refractive index profile. The CdTe based thin film solar cell device at least comprises a transparent substrate comprising a front electrode, a back contact, and a doped CdTe based absorber layer comprising vanadium as a first doping element and arranged between the front electrode and the back contact. According to the invention the doped CdTe absorber layer comprises a graded refractive index along a thickness of the CdTe based absorber layer with a lowest refractive index at a first interface of the CdTe based absorber layer oriented towards the substrate and a highest refractive index at a second interface of the CdTe based absorber layer oriented towards the back contact.

Advantageously, such a CdTe based thin film solar cell device offers a graded refractive index profile with a lowest refractive index at the first interface of the CdTe based absorber layer directed towards the substrate, which is directed to sunlight when the thin film solar cell device is in use and enables therefore improved coupling of light into the CdTe based absorber layer from the front electrode. Furthermore, such a CdTe based thin film solar cell device shows improved photovoltaic efficiency.

Vanadium enables advantageously high doping densities, almost two orders of magnitude higher than for copper doping, resulting in higher open circuit voltage of the thin film solar cell device. Furthermore advantageously, vanadium as first doping element reduces sub-bandgap related features, like recombination from defects and resulting losses in quantum efficiency and therefore reduced overall efficiency of the thin film solar cell device, known from other doping elements, like group 15 elements.

In embodiments, the substrate comprises a transparent base substrate, preferably a glass substrate. In further embodiments, the front electrode is a front electrode layer or a front electrode layer stack. In embodiments, the front electrode is an n-type front electrode. The front electrode may be made of or may comprise a transparent conductive oxide.

In embodiments, the substrate further comprises an oxygen containinglayer being a layer or layer stack comprising a high sheet resistance, a band gap higher as 3.4 eV, a valence band edge lower than the valence band edge of the CdTe based absorber layer and a conduction band edge comparable to the CdTe based absorber layer. In further embodiments, the oxygen containing layer is an oxidic buffer layer. In further embodiments the oxidic buffer layer may be, but not limiting ZnO, SnO₂ or Mg doped ZnO. In embodiments, the oxygen containing buffer layer has a thickness in the range of 1 nm to 50 nm.

In embodiments, the doped CdTe based absorber layer has a thickness in the range of 2 µm to 5 µm, preferably 3 µm.

In embodiments, the back contact is a back contact layer stack comprising a first back contact layer and a second back contact layer, wherein the first back contact layer is a Te-rich layer and the second back contact layer is a metal layer or a high resistance layer. In embodiments, the Te-rich layer is selected out of ZnTe, SbTe, Te. In further embodiments, the metal layer is a highly conductive metal layer with sheet resistance of 5 ohm respectively ohm·sq⁻¹ or lower. Highly conductive metal layers are for instance but not limiting Mo, Al, Cr or Au. A high resistance layer is a layer with a sheet resistance of at least 100 ohm respectively ohm·sq⁻¹. In embodiments, the high resistance layer is a metal nitride layer, like for instance but not limiting MoN, AIN.

In embodiments, the Te-rich layer has a thickness in the range of 5 nm to 500 nm. Furthermore, the metal layer respectively high resistance layer have a thickness in the range of 10 nm to 1000 nm respectively in the range of 1 nm to 100 nm.

In further embodiments, the Te-rich layer may be doped with a group 11 or group 15 element, preferably with Ag, Cu or N, P, As, Sb. In embodiments, the Te-rich layer comprises the group 11 or group 15 element in the range of 0.01 wt.-% to 3 wt.-%.

The CdTe based thin film solar cell device according to the invention is preferably formed by the method described above.

In embodiments, the doped CdTe based absorber layer comprises a gradient of a first doping element, i.e. vanadium, along the thickness of the CdTe based absorber layer with a highest concentration of the first doping element at the first interface of the CdTe based absorber layer.

Advantageously, the concentration of the first doping element is indirectly coupled with the refractive index. That means, a high concentration of the first doping element results in a low refractive index and vice versa.

In further embodiments, the doped CdTe based absorber layer may be a p-doped CdTe based absorber layer, an n-doped CdTe based absorber layer or a CdTe based absorber layer with a change of doping-type within the CdTe based absorber layer. region. In further embodiments, the concentration of the first doping element within the CdTe based absorber layer is in the range of 0.001 wt.-% to 1 wt.-%. In further embodiments, the concentration of the first doping element is up to 1 wt.-% at the first interface of the CdTe based absorber layer.

In embodiments, the doped CdTe based absorber layer comprises a second doping element having a gradient along the thickness of the CdTe based absorber layer with a highest concentration of the second doping element at the second interface of the CdTe based absorber layer.

Advantageously, the gradient of the second doping element limits diffusion of the first doping element towards the second interface of the CdTe based absorber layer during the activation treatment or during operation of the CdTe based thin film solar cell device by already occupying lattice positions also suitable for the first doping element. The first and the second doping elements are different doping elements.

In embodiments, the first and the second doping element are doping elements of the same or different type. In further embodiments, the first doping element may be an n-type doping element and the second doping element may be a p-type doping element or vice versa. Furthermore, the type of the doping element may depend on the oxidation state of the element within the CdTe based thin film solar cell.

In further embodiments, the concentration of the second doping element within the CdTe based absorber layer is in the range of 0.001 wt.-% to 1 wt.-%. In further embodiments, the concentration of the second doping element is up to 1 wt.-% at the second interface of the CdTe based absorber layer.

In embodiments, the second doping element is a group 11 or group 15 element. Advantageously, group 11 and group 15 elements enable manufacturing a copper free CdTe based thin film solar cell device. In further embodiments, the second doping element is selected out of N, P, As, Ag, Cu and Sb.

For realization of the invention, it is advantageous to combine the described embodiments and features of the claims as described above. However, the embodiments of the invention described in the foregoing description are examples given by way of illustration and the invention is nowise limited thereto. Any modification, variation and equivalent arrangement should be considered as being included without departing from the scope of the appended claims.

Although specific embodiments have been illustrated and described herein, it will be appreciated by those of ordinary skill in the art that a variety of alternate and/or equivalent implementations may be substituted for the specific embodiments shown and described without departing from the scope of the appended claims.

This application is intended to cover any adaptations or variations of the specific embodiments discussed herein. Therefore, it is intended that this invention is limited only by the claims.

### Exemplary embodiments

The accompanying drawings are included to provide a further understanding of embodiments of the invention and are incorporated in and constitute a part of this specification. The drawings illustrate the embodiments of the present invention and together with the description serve to explain the principles. Other embodiments of the invention and many of the intended advantages will be readily appreciated, as they become better understood by reference to the following detailed description. The elements of the drawings are not necessarily to scale relative to each other. Like reference numbers designate corresponding similar parts.
**Fig. 1A** shows a specific embodiment of the inventive method for manufacturing a CdTe based thin film solar cell device with a graded refractive index profile within the CdTe-based absorber layer.
**Fig. 1B** shows another specific embodiment of the inventive method for manufacturing a CdTe based thin film solar cell device with a graded refractive index profile within the CdTe-based absorber layer.
**Fig. 2** shows an embodiment of an inventive CdTe based thin film solar cell device with a graded refractive index profile.

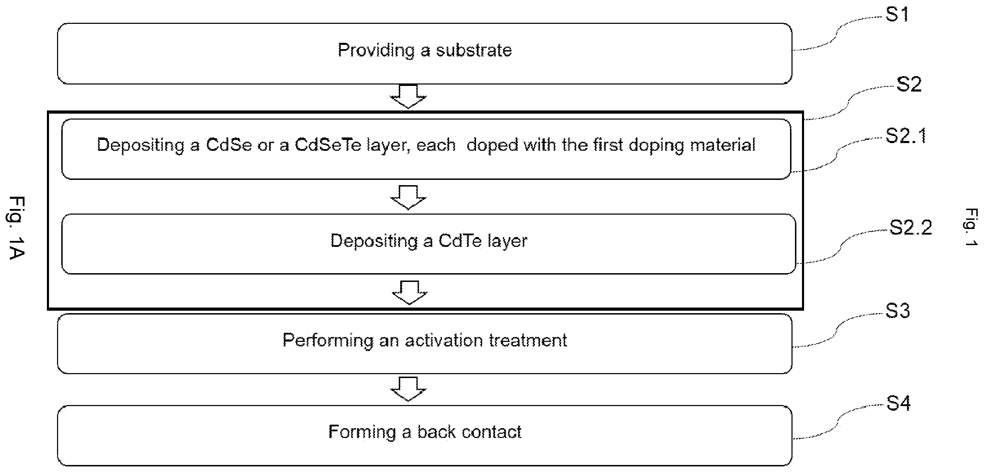

In an embodiment according to Fig. 1A, the method for manufacturing a CdTe based thin film solar cell device with a graded refractive index profile within the CdTe-based absorber layer at least comprises a step S1 of providing a transparent substrate. The transparent substrate comprises a transparent base substrate, for instance a glass substrate, a front electrode, for instance an n-type transparent conductive oxide like fluorine-doped tin-oxide, and an oxidic buffer layer, for instance magnesium doped zinc oxide (MZO). In the following step S2, a doped CdTe based absorber layer is formed as a CdTe based absorber layer stack comprising a first and a second layer. The first layer of the CdTe based absorber layer stack is formed as a first doping element containing layer wherein the first doping element is vanadium. In embodiments, the first doping element containing layer is formed in step S2.1 by depositing a CdSe layer or a CdSeTe layer each doped with vanadium for instance by depositing from a vanadium doped CdSe or CdSeTe source or by co-deposition of vanadium and CdSe or CdSeTe. The first doping element containing layer is formed with a thickness of 300nm. Further on, in step S2.2, the second layer of the CdTe based absorber layer stack is formed by depositing a CdTe layer with a thickness of 3.2 µm in vacuum of 1 Pa or under inert atmosphere. In embodiments, the second layer of the CdTe based absorber layer stack may be deposited as a doped layer, for instance a p-doped CdTe layer doped for instance with As. Methods for depositing a doped CdTe layer are well known to experts and state of the art. After forming the CdTe based absorber layer stack in step S3, an activation treatment is performed, comprising a step of applying an activation agent like CdCl₂ and a step of a thermal treatment at 400°C to 450°C in vacuum of 10 Pa with a H₂ partial pressure of 5 x 10 Pa for 15 minutes. Finally, in step S4, a back contact is formed as a back contact layer stack comprising a first back contact layer and a second back contact layer. The first back contact layer is formed by depositing a highly p-doped ZnTe with a thickness of 30 nm. The second back contact layer is deposited as metal layer, for instance Mo with a thickness of 300 nm.

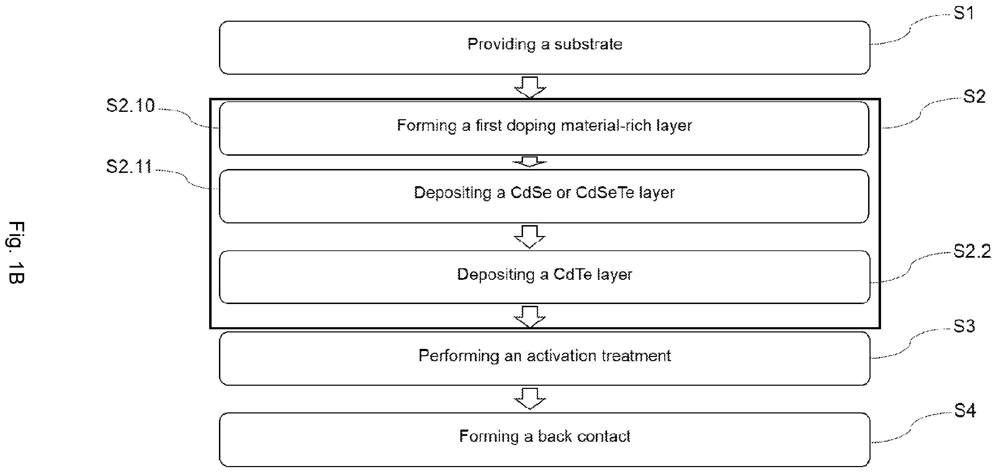

The embodiment according to Fig. 1B comprises the steps S1, S3 and S4 carried out as described for Fig. 1A. In step S2 a doped CdTe based absorber layer is formed as a CdTe based absorber layer stack comprising a first and a second layer. The first layer of the CdTe based absorber layer stack is formed as a first doping element containing layer wherein the first doping element is vanadium. According to Fig. 1B in this embodiment, the first doping element containing layer is formed by depositing a first doping element-rich layer in step S2.10, for instance a VSe₂ layer with a thickness of 50 nm in vacuum of 1 Pa, and subsequently depositing a CdSe layer or a CdSeTe layer with a thickness of 250 nm in step S2.11 in vacuum as well.

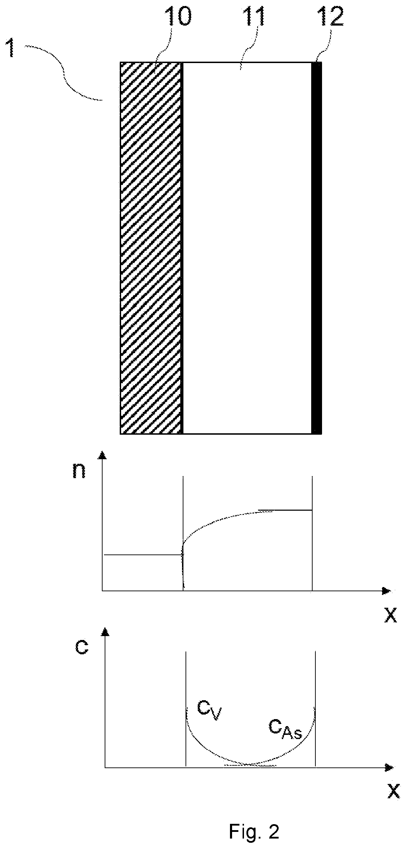

Fig. 2 shows schematically an embodiment of a CdTe based thin film solar cell device 1 not true to scale with a graded refractive index profile manufactured according to a method from Fig. 1A or Fig. 1B. The CdTe based thin film solar cell device 1 in the upper part of Fig. 2 comprises at least a transparent substrate 10 comprising a glass substrate, a front electrode of fluorine-doped tin-oxide and an oxidic buffer layer of magnesium doped zinc oxide (MZO); a doped CdTe based absorber layer 11, and a back contact 12, comprising a first back contact layer of ZnTe and a second back contact layer of Mo. The doped CdTe absorber layer 11 comprises a graded refractive index n along a thickness x of the CdTe based absorber layer 11 with a lowest refractive index n of 2.0 to 2.5 at a first interface of the CdTe based absorber layer 11 oriented towards the substrate and a highest refractive index n of 2.5 to 3 at a second interface of the CdTe based absorber layer 11 oriented towards the back contact shown schematically in the middle part of Fig. 2. The CdTe based absorber layer 11 further comprises a gradient of the first doping element, i.e. vanadium, along the thickness x of the CdTe based absorber layer 11 with a highest concentration of vanadium cᵥ up to 1 wt.-% at the first interface of the CdTe based absorber layer 11 shown in the lower part of Fig. 2. Furthermore, the doped CdTe based absorber layer 11 comprises a gradient of a second doping element, here arsenic, along the thickness x of the CdTe based absorber layer 11 with a highest concentration of arsenic c_{As} up to 1 wt.-% at the second interface of the CdTe based absorber layer 11 shown in the lower part of Fig. 2 as well. The CdTe based absorber layer 11 comprises up to 1 wt.-% vanadium and up to 0.5 wt.-% arsenic.

## Claims

1. Method for manufacturing a CdTe based thin film solar cell device with a graded refractive index profile within the CdTe-based absorber layer, at least comprising the following steps:
a) Providing a transparent substrate comprising a front electrode,
b) Forming a doped CdTe based absorber layer on the substrate,
c) Performing an activation treatment after step b),
**characterized in that** the doped CdTe based absorber layer in step b) is formed as a doped CdTe based absorber layer stack comprising a first and a second layer, wherein
the first layer is formed as a first doping element containing layer comprising vanadium as the first doping element
by depositing a first doping element-rich layer and subsequently depositing a CdSe layer or a CdSeTe layer; or
by depositing a CdSe layer or a CdSeTe layer each doped with the first doping element;
and the second layer is formed by depositing a CdTe layer.

2. Method according to claim 1, **characterized in that** the first doping element-rich layer is at least one out of the group comprising VTe₂, VSe₂ VTe₂, VSe₂, V, VO₂, NH₄VO₂, VCl₂, VCl₄.

3. Method according to claim 1 or 2, **characterized in that** the substrate provided in step a) further comprises an oxygen containing layer.

4. Method according to claim 3, **characterized in that** the oxygen containing layer is an oxidic buffer layer.

5. Method according to any of the claims 1 to 4, **characterized in that** the second layer of the CdTe based absorber layer stack is doped with a second doping element.

6. Method according to any of the claims 1 to 5, **characterized in that** the method further comprises a step d) forming a back contact after step c).

7. Method according to claim 6, **characterized in that** the back contact is formed by forming a back contact layer stack, comprising a first back contact layer and a second back contact layer, wherein the first back contact layer is a Te-rich layer and the second back contact layer is a metal layer or a high resistance layer.

8. Method according to any of the claim 1 to 7, **characterized in that** the activation treatment is performed under inert atmosphere or vacuum.

9. CdTe based thin film solar cell device with a graded refractive index profile at least comprising
- a transparent substrate comprising a front electrode,
- a back contact, and
- a doped CdTe based absorber layer comprising vanadium as a first doping element and arranged between the front electrode and the back contact,
wherein the doped CdTe absorber layer comprises a graded refractive index along a thickness of the CdTe based absorber layer with a lowest refractive index at a first interface of the CdTe based absorber layer oriented towards the substrate and a highest refractive index at a second interface of the CdTe based absorber layer oriented towards the back contact.

10. CdTe based thin film solar cell device according to claim 9, **characterized in that** the doped CdTe based absorber layer comprises a gradient of the first doping element along the thickness of the CdTe based absorber layer with a highest concentration of the first doping element at the first interface of the CdTe based absorber layer.

11. CdTe based thin film solar cell device according to claim 9 or 10, **characterized in that** the doped CdTe based absorber layer comprises a second doping element having a gradient along the thickness of the CdTe based absorber layer with a highest concentration of the second doping element at the second interface of the CdTe based absorber layer.

12. CdTe based thin film solar cell device according to any of the claims 9 or 11, **characterized in that** the second doping element is a group 11 or group 15 element.

## Patentansprüche

1. Verfahren zur Herstellung einer CdTe-basierten Dünnschichtsolarzelle mit einem Brechungsindexprofil, das einen Gradienten aufweist, innerhalb der CdTe-basierten Absorberschicht, das mindestens die folgenden Schritte umfasst:
a) Bereitstellung eines transparenten Substrats mit einer Frontelektrode,
b) Bilden einer dotierten CdTe-basierten Absorberschicht,
c) Durchführung einer Aktivierungsbehandlung nach Schritt b),
**dadurch gekennzeichnet, dass** die dotierte CdTe-basierte Absorberschicht in Schritt b) als ein Stapel dotierter CdTe-basierter Absorberschichten ausgebildet wird, der eine erste und eine zweite Schicht umfasst, wobei
die erste Schicht als erste Dotierelementschicht, die Vanadium als erstes Dotierelement enthält,
durch Aufbringen einer Schicht, die reich an dem ersten Dotierelement ist, und anschließendes Aufbringen einer CdSe-Schicht oder einer CdSeTe-Schicht; oder
durch Aufbringen einer CdSe-Schicht oder einer CdSeTe-Schicht, die jeweils mit dem ersten Dotierelement dotiert ist,
gebildet wird;
und die zweite Schicht durch Aufbringen einer CdTe-Schicht gebildet wird.

2. Verfahren nach Anspruch 1, **dadurch gekennzeichnet, dass** die Schicht, die reich an dem ersten Dotierelement ist, mindestens eines der folgenden Elemente enthält: VTe₂, VSe₂ VTe₂, VSe₂, V, VO₂, NH₄VO₂, VCl₂, VCl₄.

3. Verfahren nach Anspruch 1 oder 2, **dadurch gekennzeichnet, dass** das in Schritt a) bereitgestellte Substrat zusätzlich eine sauerstoffhaltige Schicht aufweist.

4. Verfahren nach Anspruch 3, **dadurch gekennzeichnet, dass** es sich bei der sauerstoffhaltigen Schicht um eine oxidische Pufferschicht handelt.

5. Verfahren nach einem der Ansprüche 1 bis 4, **dadurch gekennzeichnet, dass** die zweite Schicht des CdTe-basierten Absorberschichtstapels mit einem zweiten Dotierelement dotiert ist.

6. Verfahren nach einem der Ansprüche 1 bis 5, **dadurch gekennzeichnet, dass** das Verfahren ferner einen Schritt d) zur Herstellung eines Rückkontakts nach Schritt c) umfasst.

7. Verfahren nach Anspruch 6, **dadurch gekennzeichnet, dass** der Rückkontakt durch Ausbilden eines Rückkontaktschichtstapels gebildet wird, der eine erste Rückkontaktschicht und eine zweite Rückkontaktschicht umfasst, wobei die erste Rückkontaktschicht eine Te-reiche Schicht und die zweite Rückkontaktschicht eine Metallschicht oder eine hochohmige Schicht ist.

8. Verfahren nach einem der Ansprüche 1 bis 7, **dadurch gekennzeichnet, dass** die Aktivierungsbehandlung unter inerter Atmosphäre oder im Vakuum durchgeführt wird.

9. CdTe-basierte Dünnschichtsolarzelle mit einem Brechungsindexprofil, das einen Gradienten aufweist, die mindestens Folgendes umfasst
- ein transparentes Substrat mit einer Frontelektrode,
- ein Rückkontakt und
- eine dotierte CdTe-basierte Absorberschicht, die Vanadium als erstes Dotierelement enthält und zwischen der vorderen Elektrode und dem Rückkontakt angeordnet ist,
wobei die dotierte CdTe-Absorberschicht einen Brechungsindex mit einem Gradienten entlang der Dicke der CdTe-basierten Absorberschicht aufweist, mit einem niedrigsten Brechungsindex an einer ersten Grenzfläche der CdTe-basierten Absorberschicht, die zum Substrat hin orientiert ist, und einem höchsten Brechungsindex an einer zweiten Grenzfläche der CdTe-basierten Absorberschicht, die zum Rückkontakt hin orientiert ist.

10. CdTe-basierte Dünnschichtsolarzelle nach Anspruch 9, **dadurch gekennzeichnet, dass** die dotierte CdTe-basierte Absorberschicht einen Gradienten des ersten Dotierelements entlang der Dicke der CdTe-basierten Absorberschicht aufweist, wobei die höchste Konzentration des ersten Dotierelements an der ersten Grenzfläche der CdTe-basierten Absorberschicht vorliegt.

11. CdTe-basierte Dünnschichtsolarzelle nach Anspruch 9 oder 10, **dadurch gekennzeichnet, dass** die dotierte CdTe-basierte Absorberschicht ein zweites Dotierelement mit einem Gradienten entlang der Dicke der CdTe-basierten Absorberschicht aufweist, wobei die höchste Konzentration des zweiten Dotierelements an der zweiten Grenzfläche der CdTe-basierten Absorberschicht vorliegt.

12. CdTe-basierte Dünnschichtsolarzelle nach einem der Ansprüche 9 oder 11, **dadurch gekennzeichnet, dass** das zweite Dotierelement ein Element der Gruppe 11 oder der Gruppe 15 ist.

## Revendications

1. Procédé de fabrication d'un dispositif de cellule solaire à couche mince à base de CdTe avec un profil d'indice de réfraction graduel au sein de la couche absorbante à base de CdTe, comprenant au moins les étapes suivantes :
a) Fournir un substrat transparent comprenant une électrode frontale,
b) Former une couche absorbante à base de CdTe dopée sur le substrat,
c) Effectuer un traitement d'activation après l'étape b),
**caractérisé en ce que** la couche absorbante à base de CdTe dopée de l'étape b) est formée comme un empilement de couches absorbantes à base de CdTe dopées comprenant une première et une deuxième couche, dans laquelle
la première couche est formée comme une première couche d'élément dopant comprenant du vanadium comme premier élément dopant
en déposant une première couche riche en élément dopant, puis en déposant une couche de CdSe ou une couche de CdSeTe ; ou
en déposant une couche de CdSe ou une couche de CdSeTe dopée chacune avec le premier élément dopant ;
et la deuxième couche est formée en déposant une couche de CdTe.

2. Procédé selon la revendication 1, **caractérisé en ce que** la première couche riche en élément dopant est au moins l'un du groupe comprenant VTe₂, VSe₂, VTe₂, VSe₂, V, VO₂, NH₄VO₂, VCl₂, VCl₄.

3. Procédé selon la revendication 1 ou 2, **caractérisé en ce que** le substrat fourni à l'étape a) comprend en outre une couche contenant de l'oxygène.

4. Procédé selon la revendication 3, **caractérisé en ce que** la couche contenant de l'oxygène est une couche tampon oxydique.

5. Procédé selon l'une quelconque des revendications 1 à 4, **caractérisé en ce que** la deuxième couche de l'empilement de couches absorbantes à base de CdTe est dopée avec un deuxième élément de dopage.

6. Procédé selon l'une quelconque des revendications 1 à 5, **caractérisé en ce que** le procédé comprend en outre une étape d) former un contact arrière après l'étape c).

7. Procédé selon la revendication 6, **caractérisé en ce que** le contact arrière est formé en formant un empilement de couches de contact arrière, comprenant une première couche de contact arrière et une deuxième couche de contact arrière, dans laquelle la première couche de contact arrière est une couche riche en Te et la deuxième couche de contact arrière est une couche métallique ou une couche à haute résistance.

8. Procédé selon l'une quelconque des revendications 1 à 7, **caractérisé en ce que** le traitement d'activation est effectué sous atmosphère inerte ou sous vide.

9. Dispositif de cellule solaire à couche mince à base de CdTe avec un profil d'indice de réfraction graduel comprenant au moins
- un substrat transparent comprenant une électrode frontale,
- un contact arrière, et
- une couche absorbante à base de CdTe dopée comprenant du vanadium comme premier élément dopant et disposée entre l'électrode avant et le contact arrière,
dans lequel la couche absorbante de CdTe dopée comprend un indice de réfraction graduel le long d'une épaisseur de la couche absorbante à base de CdTe, avec un indice de réfraction le plus bas à une première interface de la couche absorbante à base de CdTe orientée vers le substrat et un indice de réfraction le plus élevé à une deuxième interface de la couche absorbante à base de CdTe orientée vers le contact arrière.

10. Dispositif de cellule solaire à couche mince à base de CdTe selon la revendication 9, **caractérisé en ce que** la couche absorbante à base de CdTe dopée comprend un gradient du premier élément dopant le long de l'épaisseur de la couche absorbante à base de CdTe avec une concentration la plus élevée du premier élément dopant à la première interface de la couche absorbante à base de CdTe.

11. Dispositif de cellule solaire à couche mince à base de CdTe selon la revendication 9 ou 10, **caractérisé en ce que** la couche absorbante à base de CdTe dopée comprend un deuxième élément de dopage ayant un gradient le long de l'épaisseur de la couche absorbante à base de CdTe avec une concentration la plus élevée du deuxième élément de dopage à la deuxième interface de la couche absorbante à base de CdTe.

12. Dispositif de cellule solaire à couche mince à base de CdTe selon l'une quelconque des revendications 9 ou 11, **caractérisé en ce que** le deuxième élément dopant est un élément du groupe 11 ou du groupe 15.
